# DEMANDE DE BREVET EUROPEEN

(11) **EP 0 712 166 A1**
(43) Date de publication de la demande: **15.05.1996**
(21) Numéro de dépôt: 95402482.4
(22) Date de dépôt: 07.11.1995
(51) Int. Cl.: H01L 27/146

(54) **Photodétecteur de grande dimension et procédé de réalisation d'un tel photodétecteur**

(30) Priorité: 08.11.1994 FR 9413374
(71) Demandeur: THOMSON-CSF, F-75008 Paris (FR)
(72) Inventeur: Duboz, Jean-Yves, F-92402 Courbevoie Cedex (FR); Bois, Philippe, F-92402 Courbevoie Cedex (FR)
(74) Mandataire: Guérin, Michel

(57) **Abrégé**

L'invention concerne un photodétecteur de grande dimension capable de détecter des flux lumineux de forte puissance. Il comprend un ensemble de photodétecteurs élémentaires (Edᵢ) pouvant être testés individuellement, les bons photodétecteurs (Edᵢ)₁ étant connectés en parallèle à une zone conductrice (C).

Le photodétecteur selon l'invention peut également comprendre une série de transistors (Ti) servant d'intermédiaire de connexion entre les photodétecteurs (Edᵢ) et la zone conductrice (C) ; la surface active du photodétecteur devient ainsi modulable en fonction des dimensions du faisceau à détecter.

## Description

Le domaine de l'invention est celui des photodétecteurs et plus précisément celui des photodétecteurs de grandes dimensions pour des applications spécifiques. Il peut s'agir de détection de faisceau laser de grande extension notamment dans le domaine des communications optiques à longue distance ou plus généralement pour toute l'instrumentation optique dès lors que l'on cherche à éviter l'utilisation de lentilles, qui peut notamment être rendue difficile en raison de la nature desdites lentilles dans le domaine de longueurs d'onde visées (notamment infrarouge).

Or d'une manière générale, quel que soit le matériau permettant d'élaborer un photodétecteur, la probabilité de fabriquer un photodétecteur sans défaut rédhibitoire, décroît toujours avec la taille de l'échantillon. On peut ainsi définir une taille limite comme étant la taille au-delà de laquelle la probabilité d'obtenir un photodétecteur sans défaut est inférieure à une certaine valeur (0,5 par exemple).

La taille limite, elle dépend de la nature du matériau considéré pour réaliser un photodétecteur : en infrarouge, par exemple, cette taille limite augmente lorsque l'on passe des matériaux type HgCdTe à GaAs puis à PtSi.

Parallèlement à cette taille limite, il est à noter que pour la photodétection de grande sensibilité on utilise généralement des matériaux semiconducteurs cristallins (pouvant notamment être obtenus par croissance épitaxiale) dans lesquels les défauts de croissance sont suffisamment localisés pour que la zone hors de ces défauts reste de bonne qualité.

En tenant compte de ces deux phénomènes, l'invention propose un photodétecteur de grande dimension résultant de la connexion en parallèle de photodétecteurs élémentaires dont la dimension est inférieure à la taille limite évoquée précédemment, permettant ainsi de mettre en parallèle des photodétecteurs élémentaires ayant une forte probabilité de ne pas avoir de défaut de manière à définir un photodétecteur de grandes dimensions, sans défaut puisque seuls les bons photodétecteurs élémentaires seront connectés en parallèle.

Plus précisément, l'invention a pour objet un photodétecteur caractérisé en ce qu'il comprend un substrat, une zone conductrice (C) sur le substrat et une pluralité de photodétecteurs élémentaires (Edᵢ) dont certains photodétecteurs (Edᵢ)₁ sont connectés en parallèle à la zone conductrice (C).

Le photodétecteur selon l'invention peut avantageusement comporter des zones isolantes (I) entre les photodétecteurs élémentaires (Edᵢ) et des lignes conductrices (Li) permettant d'assurer la connexion en parallèle des photodétecteurs élémentaires (Edᵢ)₁, lesdites lignes (Li) étant reliées à une ligne conductrice commune (Lc).

Dans le photodétecteur selon l'invention, les photodétecteurs élémentaires (Edᵢ) peuvent de préférence être arrangés en barrettes linéaires, ou bien encore sous forme matricielle.

L'invention a aussi pour objet un procédé de réalisation d'un photodétecteur tel que celui décrit précédemment permettant l'obtention d'un photodétecteur de grande dimension ne présentant pas de défaut.

Plus précisément, ce procédé de réalisation d'un photodétecteur est caractérisé en ce qu'il comprend les étapes suivantes :
- la réalisation d'une pluralité d'éléments photodétecteurs (Edᵢ) sur un substrat (S), séparés par des zones isolantes (I) ;
- un test individuel de bon fonctionnement de chaque élément (Edᵢ) de manière à identifier les bons photodétecteurs (Edᵢ)₁ ;
- la connexion en parallèle de l'ensemble des photodétecteurs (Edᵢ)₁ de manière à réaliser un photodétecteur de grande dimension par rapport à la dimension des photodétecteurs élémentaires.

L'invention sera mieux comprise et d'autres avantages à la lecture de la description qui va suivre, donnée à titre non limitatif et des figures annexées parmi lesquelles :
- la figure 1 illustre un exemple de photodétecteur selon l'invention composé d'une matrice de photodétecteurs élémentaires :
   * la figure 1a illustre une vue de dessus
   * la figure 1b illustre une vue en coupe
- la figure 2 illustre un exemple de photodétecteur selon l'invention composé d'un ensemble de photodétecteurs élémentaires de forme rectangulaire ;
- la figure 3 schématise un photodétecteur selon l'invention dans lequel chaque photodétecteur est connecté à la zone conductrice (C) par l'intermédiaire de transistors ;
- la figure 4 illustre les principales étapes d'un exemple de procédé selon l'invention pour élaborer un photodétecteur de grande dimension sur substrat GaAs, avec photodétecteurs élémentaires présentant des structures à puits quantiques ;
- la figure 5 illustre un exemple de photodétecteur selon l'invention dans lequel chaque élément photodétecteur (Edᵢ) est couplé à un élément photodétecteur (edi) :
   * la figure 5a montre une coupe d'un couple [(Edᵢ), (edi)] dans un exemple de réalisation
   * la figure 5b montre aussi une coupe d'un couple [(Edᵢ, (edi)] dans un second exemple de réalisation.

D'une manière générale le photodétecteur selon l'invention est constitué d'un ensemble de photodétecteurs élémentaires (Edᵢ) dont les dimensions sont inférieures aux dimensions limites, de sorte que la probabilité qu'un élément (Edᵢ) soit bon est relativement élevée (au moins 0,9).

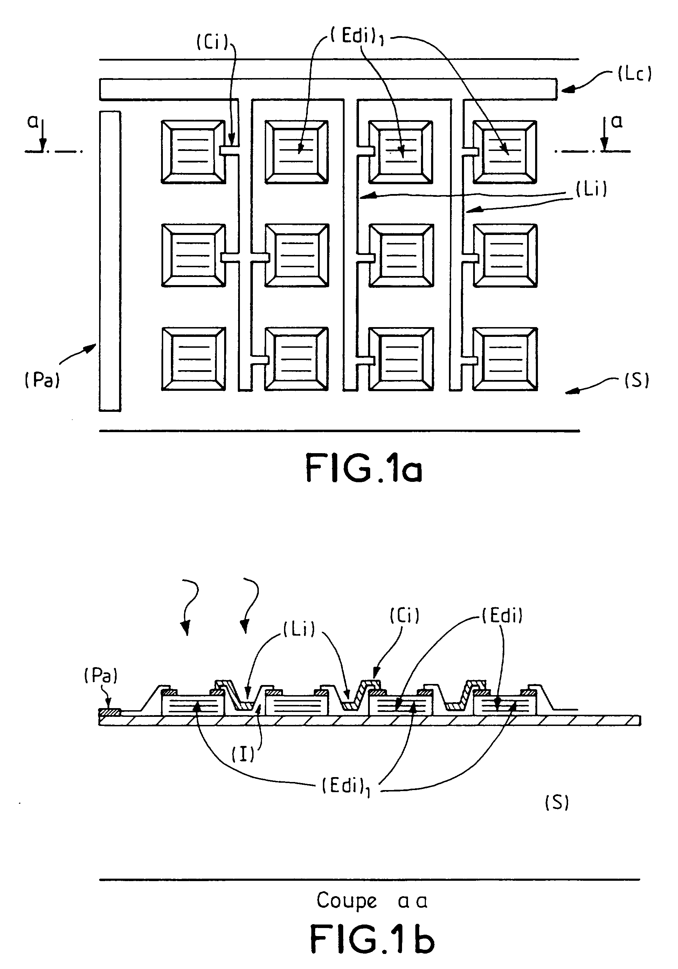

La figure 1 illustre un exemple de photodétecteurs de grande dimension, selon l'invention dans lequel les photodétecteurs élémentaires sont arrangés de façon matricielle. Il s'agit d'un photodétecteur fonctionnant en face avant, la lumière étant captée directement par les photodétecteurs élémentaires. Chaque photodétecteur élémentaire (Edᵢ) est isolé des autres photodétecteurs par une zone isolante (I). Des lignes conductrices (Li) reliées à une ligne commune (Lc) peuvent typiquement venir matérialiser la zone conductrice (Lc). Les photodétecteurs élémentaires (Edᵢ)₁ en état de bon fonctionnement sont connectés en parallèle à la zone conductrice (c), par des éléments conducteurs (Ci). La figure 1 illustre une configuration possible dans laquelle chaque ligne de photodétecteur élémentaire est séparée de sa voisine par une ligne conductrice, il est également possible d'envisager de n'introduire des lignes conductrices que toutes les deux colonnes de photodétecteurs élémentaires.

La ligne (A) quant à elle matérialise le contact dit bas qui permet d'effectuer la mesure de photodétection avec le contact dit haut qui peut être effectué au niveau de la ligne (Lc) notamment.

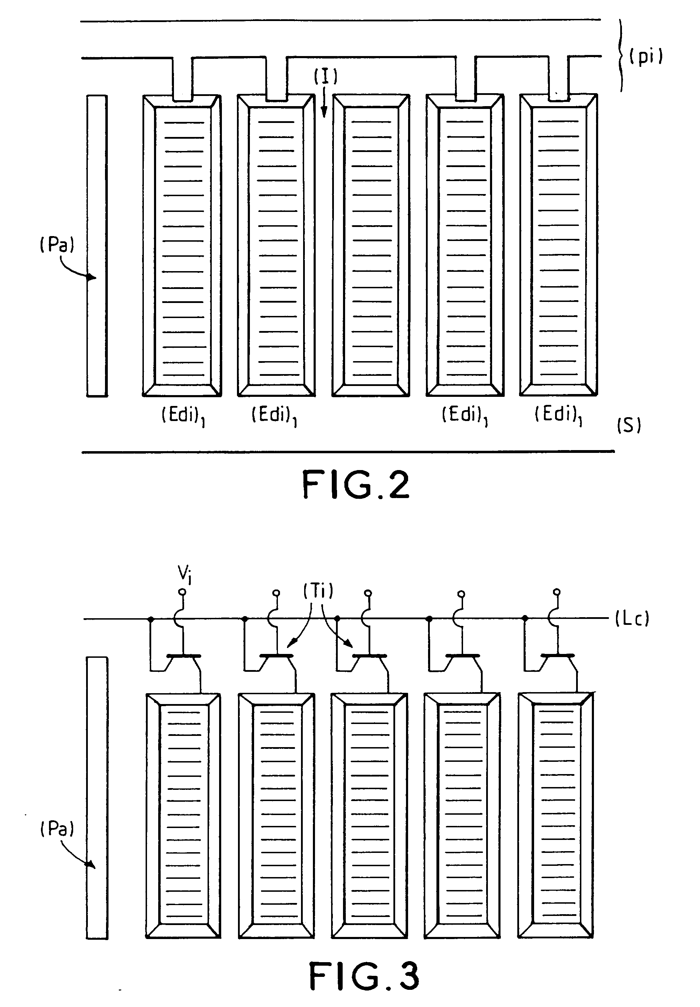

Il peut être également intéressant de réaliser des photodétecteurs élémentaires (Edᵢ) rectangulaires de plus grande dimension comme illustrées en figure 2. Différentes façons de réaliser la zone (C) peuvent être envisagées. Il peut s'agir de lignes conductrices entre photodétecteurs permettant d'assurer le contact électrique entre bons photodétecteurs de manière identique à celle illustrée en figure 1. Dans le cas de ces photodétecteurs élémentaires rectangulaires, il peut être encore plus simple de réaliser un peigne conducteur (pi) sur la zone isolante (I) comme le montre la figure 2.

Dans une variante de photodétecteur selon l'invention il peut être également intéressant de connecter les photodétecteurs élémentaires (Edᵢ) à des transistors (Ti) jouant le rôle de commutateur vers la zone conductrice (C). Ainsi il devient possible de moduler la surface sensible du photodétecteur en fonction de l'étendue du faisceau lumineux que l'on cherche à détecter. Cet aspect est attractif dans la mesure où le bruit généré par un photodétecteur dépend de la surface de ce dernier. Il n'est ainsi pas judicieux d'utiliser une surface de détecteur s pour mesurer le flux lumineux d'un faisceau optique d'étendue s/4 par exemple.

Dans un premier mode de fonctionnement, il peut s'agir d'un adressage manuel par lequel on décide d'utiliser tel ou tel photodétecteur élémentaire (Edᵢ) en appliquant une tension adéquate Vi telle qu'illustrée en figure 3. Dans un second mode de fonctionnement plus élaboré chaque photodétecteur élémentaire (Edᵢ) peut être couplé à un plus petit photodétecteur (edi) par l'intermédiaire d'un transistor (Ti). Lorsqu'un courant de photodétection apparait au niveau du photodétecteur (edi), il apparait une tension capable d'engendrer la connexion du photodétecteur (Edᵢ) associé au petit photodétecteur élémentaire (edi), à la ligne commune (Lc).

L'invention a aussi pour objet un procédé de réalisation de ce type de photodétecteur de grande dimension et les différentes étapes de réalisation de ce procédé vont maintenant être décrites.

A partir d'un substrat (S), notamment semiconducteur des photodétecteurs élémentaires (Edᵢ) sont élaborés. Il peut s'agir typiquement d'un substrat de type GaAs, comportant en surface une couche de GaAs dopé plus conductrice, permettant d'assurer les contacts électriques.

Sur un tel substrat des couches actives peuvent être réalisées, par exemple par épitaxie, pour réaliser des photodétecteurs élémentaires de grande sensibilité (et notamment des structures à puits quantiques).

A la surface de ces photodétecteurs élémentaires (Edᵢ) une seconde couche conductrice en GaAs dopé est réalisée pour favoriser les contacts extérieurs.

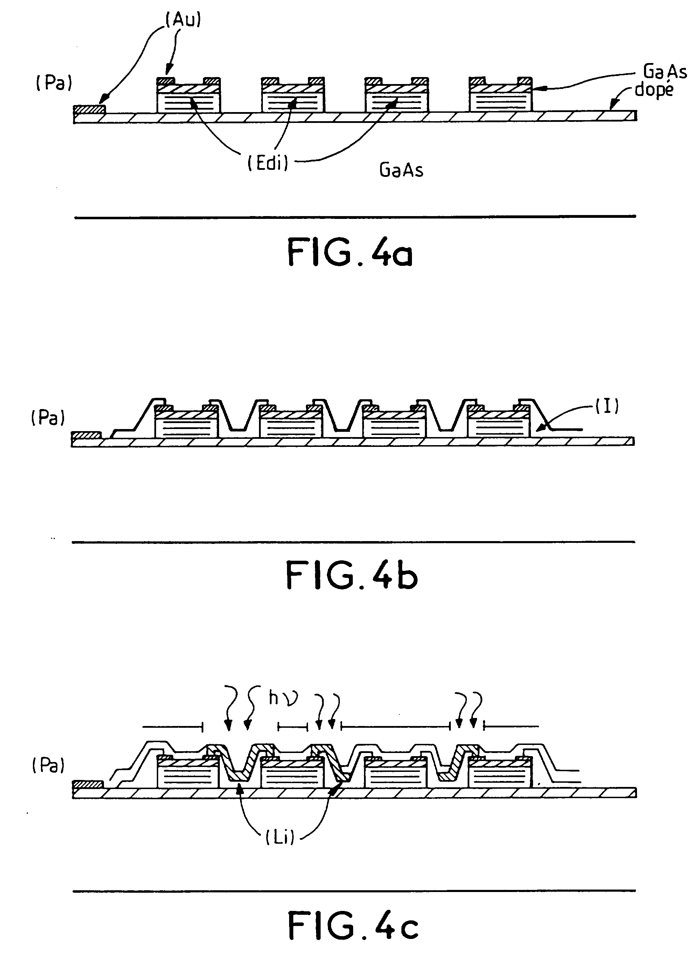

Sur l'ensemble substrat (S)/photodétecteurs (Edᵢ) on réalise localement le contact dit bas (Pa) et des zones conductrices au-dessus des détecteurs par dépôt métallique (typiquement il peut s'agir d'or). Pour un photodétecteur destiné à fonctionner en face avant, les zones conductrices sont réalisées en périphérie de détecteur pour laisser passer le flux lumineux à détecter. La figure 4 illustre les différentes étapes d'un exemple de procédé selon l'invention dans le cadre de photodétecteurs réalisés sur GaAs. La figure 4a schématise le substrat avec ces photodétecteurs et le contact bas (Pa). Il est également envisagé pour obtenir le même résultat de partir d'un substrat (S) sur lequel est préalablement réalisée la succession de couches GaAs dopé, les structures à puits quantiques la couche GaAs dopé. Dans un second temps on réalise localement des dépôts de métal (destinés à jouer le rôle d'électrodes supérieures des photodétecteurs). L'ensemble peut alors être localement gravé par gravure ionique réactive ou chimique de manière à définir les photodétecteurs élémentaires.

La figure 4b illustre une autre étape du procédé selon l'invention consistant à recouvrir localement la structure décrite en figure 4a par de l'isolant ; il peut avantageusement s'agir d'un isolant type SiO₂ ou Si₃N₄ ou bien de matériau organique tel que le polyimide ou bien encore de polymère type PMMA.

Lorsque les différents photodétecteurs (Edᵢ) sont élaborés, ils sont alors soumis individuellement à un test de bon fonctionnement.

De manière générale, les défauts pouvant exister dans les matériaux semiconducteurs utilisés dans les photodétecteurs, sont des défauts électriquement actifs qui conduisent au sein d'un photodétecteur à des courants d'obscurité très supérieure à la normale. Ils sont donc facilement repérables par mesure électrique soit à température ambiante, soit à plus basse température (dans le cas de détecteurs infrarouge fonctionnant vers 10 µm, on peut utiliser un testeur sous pointe à 77 K pour mettre en évidence les grands courants d'obscurité et par là-même repérer les photodétecteurs défaillants).

Lorsque l'on est en mesure de définir l'ensemble des photodétecteurs (Edᵢ)₁ en bon état de fonctionnement, on opère la connexion en parallèle de tous ces photodétecteurs. Pour cela on va métalliser sélectivement, de manière à définir la zone conductrice (C) à laquelle on va connecter les différents détecteurs (Edᵢ). Ainsi, dans un premier temps on peut définir des lignes métalliques (en or notamment) (Li) sur des zones isolantes.

Les connexions des éléments (Edᵢ)₁ à cette zone conductrice commune (C) peuvent alors être réalisées de différentes manières. Il est en effet possible de déposer une résine chargée de métal. En chauffant localement avec un laser excimère on est capable d'évaporer la résine pour ne laisser présent que le métal. Les zones non irradiées par le laser et qui sont encore recouvertes de résine chargée peuvent ensuite être dissoutes, seules les zones irradiées sont alors métallisées comme l'illustre la figure 4c. Sur cette figure, le laser est schématisé par la notation hυ, les zones irradiées donc métallisées deviennent sombres par rapport aux zones non irradiées de résine chargée destinée à être éliminées chimiquement.

Selon d'autres procédés d'utilisation de laser excimère, il est possible également de métalliser l'ensemble de la surface du substrat, puis à l'aide du laser excimère de venir retirer la métallisation sur les éléments (Edᵢ) que l'on ne souhaite pas connecter.

Lorsque l'ensemble des connexions électriques a ainsi été établi entre les différents bons photodétecteurs élémentaires (Edᵢ)₁, le photodétecteur selon l'invention est alors en mesure de fonctionner, la mesure étant effectuée entre le contact (Pa) et le contact haut (Pb) pris sur la zone (C).

Dans le cas de photodétecteur selon l'invention dans lequel les photodétecteurs élémentaires (Edᵢ) sont couplés à des petits photodétecteurs élémentaires (edi) par l'intermédiaire de transistors (Ti), nous allons décrire deux types de configurations possibles.

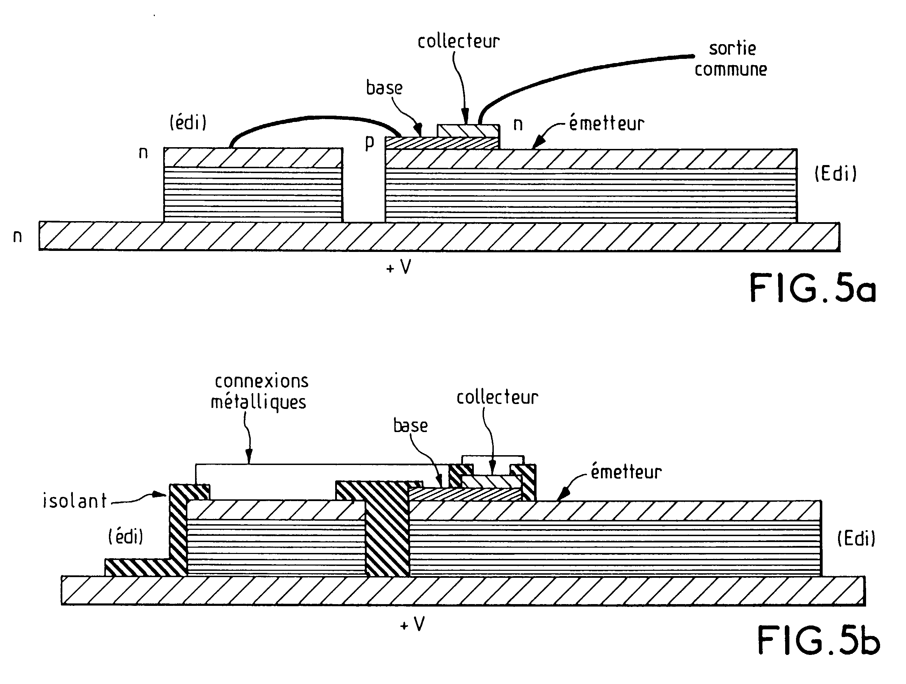

Dans un premier cas de figure, on fait croître à partir d'un substrat type GaAs, dopé en surface (couche n), deux séries de photodétecteurs élémentaires (couches à puits quantiques par exemple), chaque photodétecteur étant ensuite recouvert à son tour d'une couche dopée n de GaAs par exemple. On réalise alors sur chaque élément (Edᵢ), un transistor à l'aide d'une couche dopée p, puis d'une couche dopée n comme l'illustre la figure 5a. La couche commune dopée n sur l'ensemble du substrat étant reliée à un potentiel +V. Les contacts électriques peuvent être assurés par des fils entre la couche supérieure dopée n du photodétecteur (edi) et la couche dopée p du photodétecteur (Edᵢ).

Dans une seconde configuration plus élaborée, les connexions électriques peuvent être assurées par dépôt d'isolant entre photodétecteurs élémentaires suivi d'un dépôt métallique come l'illustre la figure 5b. Sur l'ensemble des figures 5a et 5b, les différents éléments (base, collecteur, émetteur) constitutifs des transistors (Ti) ont été indiqués.

## Revendications

1. Photodétecteur caractérisé en ce qu'il comprend un substrat, une zone conductrice (C) sur le substrat et une pluralité de photodétecteurs élémentaires (Edᵢ) dont certains photodétecteurs (Edᵢ)₁ sont connectés en parallèle à la zone conductrice (C).

2. Photodétecteur selon la revendication 1, caractérisé en ce que le substrat comporte des éléments détecteurs (Edᵢ), des zones isolantes entre les éléments détecteurs (Edᵢ) et des lignes conductrices sur les zones isolantes, lesdites lignes conductrices (Li) permettant d'assurer la connexion en parallèle des photodétecteurs élémentaires (Edᵢ)₁ et étant reliées à une même ligne conductrice (Lc).

3. Photodétecteur selon l'une des revendications 1 ou 2, caractérisé en ce qu'il comprend des photodétecteurs élémentaires (Edᵢ) de forme rectangulaire.

4. Photodétecteur selon l'une des revendications 1 ou 2, caractérisé en ce qu'il comprend une matrice de photodétecteurs élémentaires (Edᵢ).

5. Photodétecteur selon l'une des revendications 1 à 4, caractérisé en ce que le substrat comprend une surface conductrice avec une zone de contact bas (Pa), une pluralité de photodétecteurs élémentaires (Edᵢ), une zone conductrice (C) isolée de la surface conductrice du substrat par une zone isolante (I), un sous-ensemble de photodétecteurs (Edᵢ)₁ reliés électriquement à la zone conductrice (C), ladite zone conductrice (C) assurant le contact haut (Pb) du photodétecteur.

6. Photodétecteur selon l'une des revendications 1 à 5, caractérisé en ce que chaque photodétecteur élémentaire (Edᵢ) est connecté à la zone conductrice (C) par l'intermédiaire d'un transistor (Ti) de manière à moduler la surface active du photodétecteur.

7. Photodétecteur selon la revendication 6, caractérisé en ce que chaque photodétecteur élémentaire (Edᵢ) est couplé à un plus petit photodétecteur élémentaire (edi) par l'intermédiaire d'un transistor (Ti), la lumière perçue par le photodétecteur (edi) permettant la connexion du photodétecteur associé (Edᵢ) à la zone conductrice (C).

8. Procédé de réalisation d'un photodétecteur, caractérisé en ce qu'il comprend les étapes suivantes :
- la réalisation d'une pluralité d'éléments photodétecteurs (Edᵢ) sur un substrat (S), séparés par des zones isolantes (I) ;
- un test individuel de bon fonctionnement de chaque élément (Edᵢ) de manière à identifier les bons photodétecteurs (Edᵢ)₁ ;
- la connexion en parallèle de l'ensemble des photodétecteurs (Edᵢ)₁ de manière à réaliser un photodétecteur de grande dimension par rapport à la dimension des photodétecteurs élémentaires.

9. Procédé de réalisation d'un photodétecteur selon la revendication 8, caractérisé en ce qu'il comprend le dépôt de lignes conductrices sur les zones isolantes (I), lesdites lignes (Li) étant reliées à une ligne commune (Lc) de manière à assurer la connexion en parallèle des photodétecteurs élémentaires (Edᵢ)₁.

10. Procédé de réalisation d'un photodétecteur selon l'une des revendications 8 ou 9, caractérisé en ce que le test de bon fonctionnement est effectué avec une pointe placée successivement sur chaque photodétecteur élémentaire (Edᵢ) pour déterminer des courants d'obscurité importants.

11. Procédé de réalisation d'un photodétecteur selon l'une des revendications 8 à 10, caractérisé en ce que la connexion en parallèle de photodétecteurs (Edᵢ)₁ comprend :
- le dépôt d'une résine chargée métalliquement ;
- l'irradiation par un laser excimère des zones à connecter de manière à éliminer la résine et à conserver le métal ;
- l'élimination chimique des zones non irradiées de résine chargée.
